# FASCICULE DE BREVET EUROPEEN

(11) **EP 2 686 637 B1**
(45) Date de publication et mention de la délivrance du brevet: **25.11.2015**
(21) Numéro de dépôt: 12710766.2
(22) Date de dépôt: 28.02.2012
(51) Int. Cl.: G01D 5/20, G01D 11/24, G01D 18/00, G01B 7/02, G01B 7/14, H03K 17/95

(54) **CAPTEUR INDUCTIF DE PROXIMITE ET PROCEDE DE MONTAGE DUDIT CAPTEUR**
INDUKTIVER NÄHERUNGSSENSOR UND VERFAHREN ZUR MONTAGE DIESES SENSORS
INDUCTIVE PROXIMITY SENSOR AND METHOD OF MOUNTING SAID SENSOR

(30) Priorité: 15.03.2011 FR 1100777
(43) Date de publication de la demande: 22.01.2014
(73) Titulaire: Crouzet Automatismes, 26000 Valence (FR)
(72) Inventeur: Giroud, Pierre, 38050 Grenoble Cedex 9 (FR)
(74) Mandataire: GIE Innovation Competence Group
(86) Numéro de dépôt international: PCT/FR2012/000070
(87) Numéro de publication internationale: WO 2012/123647

(56) Documents cités:
- EP-B1- 1 264 404
- FR-A1- 2 445 598
- GB-A- 1 054 341
- US-A- 3 898 601

## Description

### DOMAINE TECHNIQUE DE L'INVENTION

L'invention est relative à capteur inductif comportant un boitier dans lequel est positionné un noyau ferromagnétique ayant une forme de U. Le noyau comporte deux branches externes s'étendant selon une direction longitudinale et une branche transverse reliant lesdites deux branches. Deux bobines de détection sont disposées respectivement sur les branches externes du noyau et sont destinées à être reliés à des moyens de traitement. Des moyens de calibrage sont positionnés entre les deux branches externes du noyau magnétique, un positionnement longitudinal desdits moyens de calibrages par rapport à l'extrémité des branches externes étant ajustable.

L'invention est aussi relative à un procédé de montage dudit capteur selon l'invention.

### ETAT DE LA TECHNIQUE ANTERIEURE

L'utilisation de capteur inductif pour la détection de cible ferromagnétique, non perméable ou magnétique est connue.

Comme décrit dans le document EP1264404, le détecteur de proximité comporte un noyau électromagnétique en forme de U. Le détecteur comporte en outre deux bobines disposées respectivement sur les branches du noyau en forme de U.

Les bobines sont aptes à produire un champ électromagnétique variable. La présence d'un objet métallique dans un environnement proche de l'extrémité des branches du U modifie la reluctance du système électromagnétique. La variation de la reluctance est mesurée à travers la variation de l'inductance et/ou de la résistance des bobines.

A titre d'exemple, en présence d'objet conducteur en cuivre ou en aluminium, l'inductance de la bobine décroit lorsque l'objet se trouve dans le champ magnétique produit par les bobines. Toujours à titre d'exemple, en présence d'objet magnétique tel qu'un aimant, le noyau magnétique du capteur tend à se saturer et l'impédance de la bobine varie.

Le dispositif selon le document EP1264404 comporte des moyens de calibrage qui sont positionnés de préférence entre les deux branches du noyau magnétique en forme de U. A titre d'exemple de réalisation, les moyens de calibrages comportent un boulon de calibrage. La position du boulon de calibrage par rapport à l'extrémité des branches du U du noyau est ajustable pour changer le niveau d'inductance qui est mesuré par les bobines de détection positionnées autour du noyau. Selon ce mode de réalisation connu, le boulon comporte une zone filetée destinée à faciliter le mouvement du boulon et le calibrage de l'ensemble. L'ajout de pièce pour ce réglage complexifie alors l'assemblage du détecteur de proximité.

Le document GB1054341A décrit une bobine d'induction avec un noyau ferromagnétique qui est ajustable à l'aide d'une tige de calibrage qui est vissée par auto-taraudage dans une douille déformable placée dans une ouverture du noyau.

### EXPOSE DE L'INVENTION

L'invention vise donc à remédier aux inconvénients de l'état de la technique, de manière à proposer un détecteur de proximité comportant des moyens de calibrage tel que défini dans la revendication 1.

Le capteur inductif selon l'invention comporte une pièce intermédiaire de fixation des moyens de calibrage sur le noyau ferromagnétique, la pièce intermédiaire de fixation étant placée en force dans une ouverture réalisée dans la branche transverse du noyau ferromagnétique. Les moyens de calibrage comportent une zone filetée apte à se visser dans un trou lisse pratiqué dans la pièce intermédiaire de fixation de manière à se déplacer entre les branches externes.

La pièce intermédiaire de fixation comporte une première zone cylindrique traversant le noyau ferromagnétique et comportant une extrémité souple déformable et de forme tronconique de manière à être positionnée à l'intérieur des branches externes et à assurer un coincement de ladite pièce après l'enfoncement des moyens de calibrage dans le trou lisse, et une seconde zone cylindrique positionnée à l'extérieur du noyau.

Selon un mode de développement de l'invention, l'ouverture de la branche transverse du noyau ferromagnétique est débouchant. La pièce intermédiaire de fixation est traversée par un trou lisse de manière à ce qu'une première extrémité des moyens de calibrage se trouve entre les branches externes du noyau ferromagnétique et qu'une seconde extrémité soit positionnée à l'extérieur desdites branches externes.

De préférence, la première et la seconde zone cylindrique sont reliées par une zone d'épaulement en appui sur la branche transverse du noyau ferromagnétique.

De préférence, le capteur inductif comporte de la résine dure entre une paroi interne de la seconde zone cylindrique et la paroi externe des moyens de calibrage.

Avantageusement, la pièce intermédiaire de fixation est réalisée dans un matériau isolant.

Avantageusement, la pièce intermédiaire de fixation comporte plus de 50% polyformaldéhyde.

Le procédé selon l'invention consiste à positionner en force la pièce intermédiaire de fixation dans le trou pratiqué dans la branche transverse du noyau ferromagnétique, puis à visser en auto-taraudant les moyens de calibrage à l'intérieur du trou pratiqué dans la pièce intermédiaire de fixation. Enfin le procédé consiste à verser de la résine durcissante dans la cavité de la pièce intermédiaire de fixation pour bloquer tout mouvement de vissage des moyens de calibrage relativement à la pièce intermédiaire de fixation.

### BREVE DESCRIPTION DES FIGURES

D'autres avantages et caractéristiques ressortiront plus clairement de la description qui va suivre de modes particuliers de réalisation de l'invention, donnés à titre d'exemples non limitatifs, et représentés aux dessins annexés sur lesquels :
les figures 1 et 2 représentent des vues en coupe d'un capteur inductif de proximité selon un premier mode préférentiel de réalisation de l'invention ;

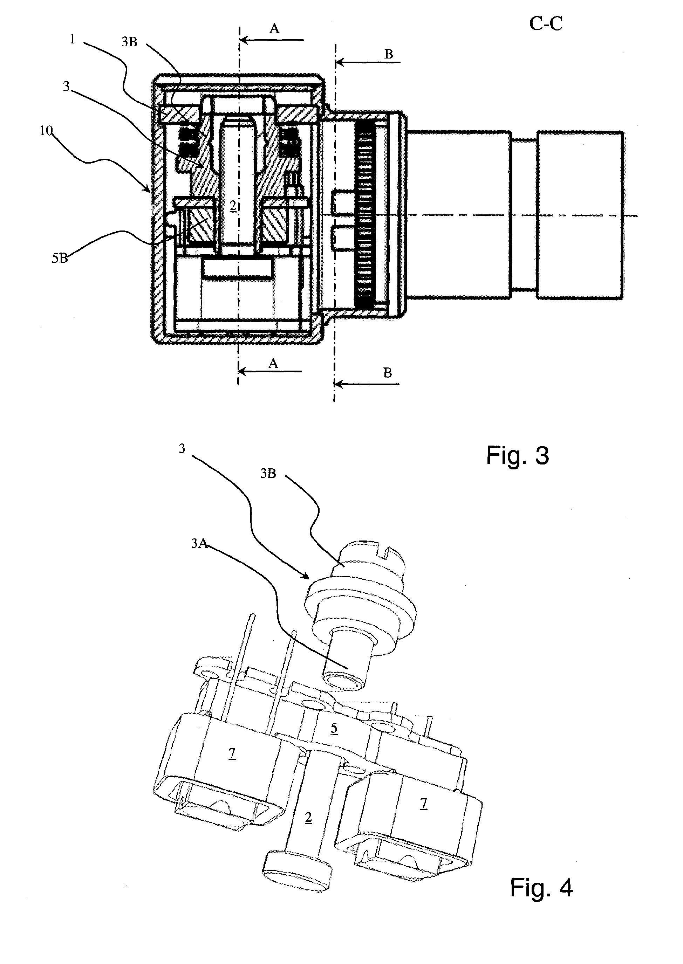

la figure 3 représente un vue en coupe de coté d'un capteur inductif de proximité selon la figure 2 ;
la figure 4 représente, un vue en perspective d'un capteur inductif de proximité en cours de montage ;

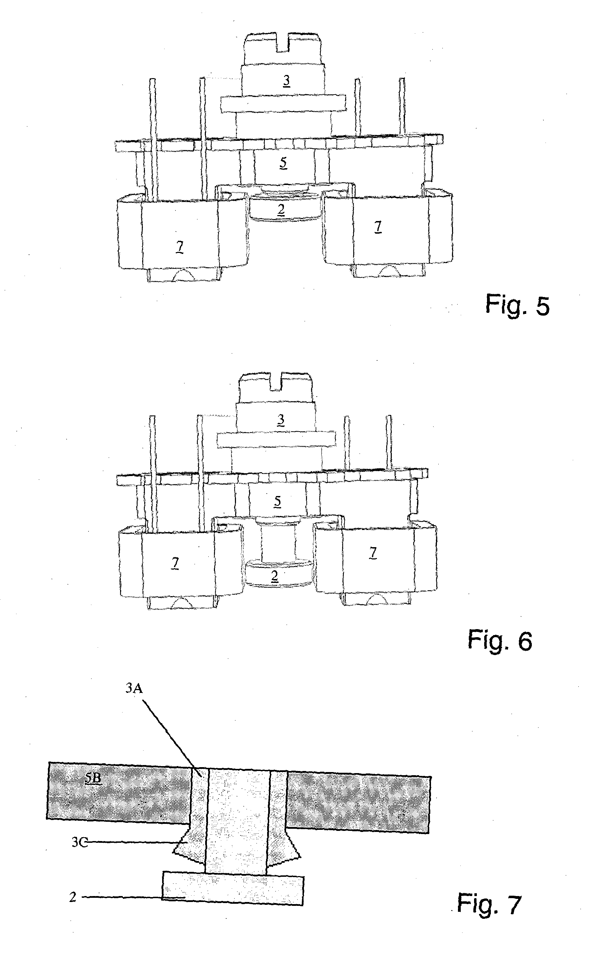

les figures 5 et 6 représentent des vues en perspectives d'un capteur inductif de proximité dans différentes positions de calibrage ;
la figure 7 représente vue de détail des moyens de calibrage d'un capteur inductif selon la figure 1.

### DESCRIPTION DETAILLEE D'UN MODE DE REALISATION

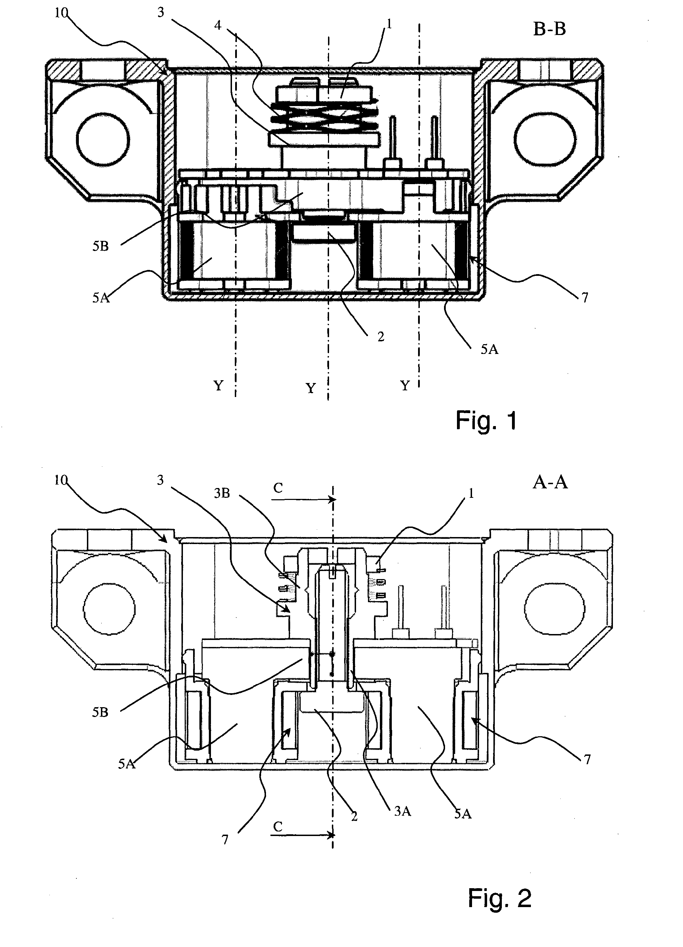

Selon un mode préférentiel de réalisation de l'invention tel que représenté sur la figure 1, le capteur inductif pour la détection de cible comporte un noyau ferromagnétique 5 ayant une forme de U. Le noyau comporte alors deux branches externes 5A s'étendant selon un axe longitudinal Y et une branche transverse 5B reliant lesdites deux branches. La branche transverse est sensiblement perpendiculaire à l'axe longitudinal Y.

Deux bobines de détection 7 sont disposées respectivement sur les branches externes 5A du noyau 5. Les bobines sont destinées à être reliés à des moyens de traitement non représentés.

Le capteur inductif comporte des moyens de calibrage 2 positionnés entre les deux branches externes 5A du noyau magnétique 5. Les moyens de calibrages sont réalisés dans un matériau ferromagnétique. Un positionnement longitudinal desdits moyens de calibrages par rapport à l'extrémité des branches du U autorise un calibrage du capteur inductif. Le positionnement des moyens de calibrage par rapport au noyau est alors ajustable. A titre d'exemple, les moyens de calibrage 2 se déplacent de manière parallèle entre aux branches externes 5A.

Tous les éléments constitutifs du capteur décrits ci-dessus sont positionnés à l'intérieur d'un boitier 10.

Selon un mode préférentiel de réalisation de l'invention, le capteur inductif comporte une pièce intermédiaire de fixation 3 des moyens de calibrage 2 sur le noyau ferromagnétique 5.

Ladite pièce intermédiaire de fixation 3 est placée en force dans une ouverture réalisée dans la branche transverse 5B du noyau ferromagnétique 5. En d'autres termes, la pièce intermédiaire de fixation 3 est chassée en force dans le noyau magnétique 5. La pièce intermédiaire de fixation est creuse et comporte de préférence un trou lisse dont l'axe longitudinal est parallèle avec celui des branches externes 5A du noyau.

Les moyens de calibrage sont de forme allongée, de préférence cylindrique. A Les moyens de calibrage comportent une zone filetée à une extrémité de la forme allongée. Cette zone filetée est apte à se visser en force dans le trou lisse pratiqué dans la pièce intermédiaire de fixation.

La pièce intermédiaire de fixation 3 est réalisée dans un matériau isolant polymère offrant une certaine souplesse et une faible friction. A titre d'exemple, la pièce intermédiaire de fixation comporte plus de 50% polyformaldéhyde. Le choix du matériau autorise un auro-taraudage de la pièce intermédiaire de fixation 3 par la zone filetée des moyens de calibrage 2. En fonction de l'enfoncement de la zone filetée dans le trou lisse auro-taraudé par le passage de la zone filetée, les moyens de calibrage peuvent se déplacer et se positionner entre les branches externes 5A.

Selon un mode de réalisation de l'invention, l'ouverture de la branche transverse 5B du noyau ferromagnétique 5 est débouchant. La pièce intermédiaire de fixation 3 est alors traversée par un trou lisse de manière à ce qu'une première extrémité des moyens de calibrage 2 se trouve entre les branches externes 5A du noyau ferromagnétique 5 et qu'une seconde extrémité soit positionnée à l'extérieur desdites branches externes 5A. A titre d'exemple de réalisation, la pièce intermédiaire de fixation 3 comporte une première zone cylindrique 3A traversant le noyau ferromagnétique 5 pour être positionnée à l'intérieur des branches externes 5A et second zone cylindrique 3B positionnée à l'extérieur. La première et la seconde zone cylindrique sont reliées par une zone d'épaulement en appui sur la branche transverse 5B du noyau ferromagnétique 5.

Le vissage des moyens de calibrage 2 dans la pièce intermédiaire de fixation 3 est donc naturellement freiné. En outre, tout jeu nuisible entre les deux pièces 2, 3 est annulé pour assurer une fiabilité satisfaisante du réglage.

Selon un mode particulier de réalisation de l'invention, l'ensemble des pièce comprenant les moyens de calibrage 2, la pièce intermédiaire de fixation 3, le noyau magnétique 5, et les bobines 7 est maintenu en force dans le boîtier par un ressort 4 et un verrou 1. Le ressort 4 assure un maintien constant tout en éliminant les contraintes thermiques différentielles qui pourraient apparaître de façon nuisible à la précision du capteur.

Selon un mode particulier de réalisation, la première zone cylindrique de la pièce intermédiaire de fixation 3 comporte une extrémité souple déformable et de forme tronconique 3C de manière à assurer un coincement de ladite pièce après l'enfoncement des moyens de calibrage dans le trou lisse. En effet, la forme conique vient s'appuyer sur l'arête sur la culasse et empêche le mouvement de l'ensemble formé par les moyens de réglage 2 et de la pièce intermédiaire de fixation 3. Ce verrouillage est rendu total par l'insertion par vissage forcé des moyens de calibrage 2 dans la pièce intermédiaire de fixation 3.

La second zone cylindrique 3B de la pièce intermédiaire de fixation est creuse et permet un accès à une extrémité des moyens de réglage. Lorsque le réglage des moyens de calibrage 2 est terminé, le volume disponible à l'intérieur de la seconde zone cylindrique 3B est rempli de résine dure. La présence de cette résine permet assurer une sécurité de positionnement des moyens de calibrage 2 par rapport à la pièce intermédiaire de fixation 3, notamment un blocage en rotation.

L'invention est aussi relative à un procédé de montage et de calibrage d'un capteur inductif tel que défini ci-dessus. Le procédé consiste à :
- positionner en force la pièce intermédiaire de fixation 3 dans le trou pratiqué dans la branche transverse 5B du noyau ferromagnétique 5. Le positionnement en force consiste en un chassage en translation selon une direction sensiblement parallèle à l'axe longitudinal des branches externes 5A de la culasse magnétique 5.
- visser en auto-taraudant les moyens de calibrage 2 à l'intérieur du trou pratiqué dans la pièce intermédiaire de fixation 3.

Le procédé de montage et de calibrage du capteur in consiste à verser de la résine durcissante dans la cavité présente dans la second zone cylindrique 3B de la pièce intermédiaire de fixation 3 pour bloquer tout mouvement de vissage des moyens de calibrage 2 relativement à la pièce intermédiaire de fixation 3.

## Revendications

1. Capteur inductif comportant un boitier (10) dans lequel sont positionnés :
- un noyau ferromagnétique (5) ayant une forme de U, noyau comportant deux branches externes (5A) s'étendant selon une direction longitudinale (Y) et une branche transverse (5B) reliant lesdites deux branches ;
- deux bobines de détection (7) disposées respectivement sur les branches externes (5A) du noyau (5) et étant destinées à être reliées à des moyens de traitement ;
- des moyens de calibrage (2) positionnés entre les deux branches externes (5A) du noyau magnétique (5), un positionnement longitudinal desdits moyens de calibrages par rapport à l'extrémité des branches externes (5A) étant ajustable ;
capteur **caractérisé en ce qu'**il comporte une pièce intermédiaire de fixation (3) des moyens de calibrage (2) sur le noyau ferromagnétique (5),
- lesdits moyens de calibrage (2) comportant une zone filetée apte à se visser dans un trou lisse pratiqué dans la pièce intermédiaire de fixation de manière à se déplacer entre les branches externes (5A) ;
- ladite pièce intermédiaire de fixation (3) placée en force dans une ouverture réalisée dans la branche transverse (5B) comportant
- une première zone cylindrique (3A) traversant le noyau ferromagnétique (5) et comportant une extrémité souple déformable et de forme tronconique (3C) de manière à être positionnée à l'intérieur des branches externes (5A) et à assurer un coincement de ladite pièce après l'enfoncement des moyens de calibrage (2) dans le trou lisse, et
- une seconde zone cylindrique (3B) positionnée à l'extérieur du noyau.

2. Capteur inductif selon la revendication 1, **caractérisé en ce que** la première et la seconde zone cylindrique (3A, 3B) sont reliées par une zone d'épaulement en appui sur la branche transverse (5B) du noyau ferromagnétique (5).

3. Capteur inductif selon les revendications 1 ou 2, **caractérisé en ce que** l'ouverture de la branche transverse (5B) du noyau ferromagnétique (5) est débouchant et **en ce que** la pièce intermédiaire de fixation (3) est traversée par un trou lisse de manière à ce qu'une première extrémité des moyens de calibrage se trouve entre les branches externes (5A) du noyau ferromagnétique (5) et qu'une seconde extrémité soit positionnée à l'extérieur desdites branches externes (5A).

4. Capteur inductif selon la revendication 3, **caractérisé en ce qu'**il comporte de la résine dure entre une paroi interne de la seconde zone cylindrique (3B) et la paroi externe des moyens de calibrage (2).

5. Capteur inductif selon l'une quelconques des revendications précédentes, **caractérisé en ce que** la pièce intermédiaire de fixation (3) est réalisée dans un matériau isolant

6. Capteur inductif selon la revendication 5, **caractérisé en ce que** la pièce intermédiaire de fixation (3) comporte plus de 50% polyformaldéhyde.

7. Procédé de montage d'un capteur inductif selon les revendications précédentes **caractérisé en ce qu'**il consiste à :
- positionner en force la pièce intermédiaire de fixation (3) dans le trou pratiqué dans la branche transverse (5B) du noyau ferromagnétique (5),
- visser en auto-taraudant les moyens de calibrage (2) à l'intérieur du trou pratiqué dans la pièce intermédiaire de fixation (3).

8. Procédé de montage d'un capteur inductif selon la revendication 7 **caractérisé en ce qu'**il consiste à verser de la résine dans la cavité de la pièce intermédiaire de fixation (3) pour bloquer tout mouvement de vissage des moyens de calibrage (2) relativement à la pièce intermédiaire de fixation (3).

## Patentansprüche

1. Induktiver Sensor, umfassend ein Gehäuse (10), in dem Folgendes angeordnet ist:
- ein ferromagnetischer Kern (5), der U-förmig ist, wobei der Kern zwei äußere Schenkel (5A), die sich in einer Längsrichtung (Y) erstrecken, und einen transversalen Schenkel (5B) aufweist, der die zwei Schenkel verbindet;
- zwei Erfassungsspulen (7), die jeweils auf den äußeren Schenkeln (5A) des Kerns (5) angeordnet sind und dazu bestimmt sind, an Bearbeitungsmittel angeschlossen zu werden;
- Kalibriermittel (2), die zwischen den zwei äußeren Schenkeln (5A) des magnetischen Kerns (5) angeordnet sind, wobei eine Längspositionierung der Kalibriermittel in Bezug auf das Ende der äußeren Schenkel (5A) einstellbar ist;
wobei der Sensor **dadurch gekennzeichnet ist, dass** er ein Befestigungszwischenstück (3) der Kalibriermittel (2) auf dem ferromagnetischen Kern (5) aufweist,
- wobei die Kalibriermittel (2) einen Gewindebereich aufweisen, der geeignet ist, in einem glatten Loch, das in dem Befestigungszwischenstück gebildet ist, eingeschraubt zu werden, um sich zwischen den äußeren Schenkeln (5A) zu bewegen;
- wobei das Befestigungszwischenstück (3), das mit Kraft in einer Öffnung angeordnet ist, die in dem transversalen Schenkel (5B) gebildet ist, Folgendes aufweist:
- einen ersten zylindrischen Bereich (3A), der den ferromagnetischen Kern (5) durchquert und ein verformbares, flexibles und kegelstumpfförmiges Ende (3C) aufweist, um im Inneren der äußeren Schenkel (5A) angeordnet zu werden und ein Einklemmen des Stücks nach dem Eindrücken der Kalibriermittel (2) in dem glatten Loch zu gewährleisten und
- einen zweiten zylindrischen Bereich (3B), der außerhalb des Kerns angeordnet ist.

2. Induktiver Sensor nach Anspruch 1, **dadurch gekennzeichnet, dass** der erste und der zweite zylindrische Bereich (3A, 3B) durch einen Schulterbereich, der auf dem transversalen Schenkel (5B) des ferromagnetischen Kerns (5) aufliegt, verbunden sind.

3. Induktiver Sensor nach den Ansprüchen 1 oder 2, **dadurch gekennzeichnet, dass** die Öffnung des transversalen Schenkels (5B) des ferromagnetischen Kerns (5) mündend ist und dass das Befestigungszwischenstück (3) durch ein glattes Loch derart durchquert ist, dass sich ein erstes Ende der Kalibriermittel zwischen den äußeren Schenkeln (5A) des ferromagnetischen Kerns (5) befindet und dass ein zweites Ende außerhalb der äußeren Schenkel (5A) angeordnet ist.

4. Induktiver Sensor nach Anspruch 3, **dadurch gekennzeichnet, dass** er Hartharz zwischen einer Innenwand des zweiten zylindrischen Bereichs (3B) und der Außenwand der Kalibriermittel (2) aufweist.

5. Induktiver Sensor nach einem der vorhergehenden Ansprüche, **dadurch gekennzeichnet, dass** das Befestigungszwischenstück (3) aus einem isolierenden Material erstellt ist.

6. Induktiver Sensor nach Anspruch 5, **dadurch gekennzeichnet, dass** das Befestigungszwischenstück (3) mehr als 50 % Polyformaldehyd aufweist.

7. Verfahren zur Montage eines induktiven Sensors nach einem der vorhergehenden Ansprüche, **dadurch gekennzeichnet, dass** es Folgendes aufweist:
- Positionieren mit Kraft des Befestigungszwischenstücks (3) in die Öffnung, die in dem transversalen Schenkel (5B) des ferromagnetischen Kerns (5) gebildet ist,
- selbstschneidendes Einschrauben der Kalibriermittel (2) ins Innere der Öffnung, die in dem Befestigungszwischenstück (3) gebildet ist,

8. Verfahren zur Montage eines induktiven Sensors nach Anspruch 7, **dadurch gekennzeichnet, dass** es darin besteht, Harz in den Hohlraum des Befestigungszwischenstücks (3) zu gießen, um jegliche Schraubbewegung der Kalibriermittel (2) in Bezug auf das Befestigungszwischenstück (3) zu blockieren.

## Claims

1. Inductive sensor comprising a casing (10) in which the following are positioned:
- a U-shaped ferromagnetic core (5) comprising two outer branches (5A) extending in a longitudinal direction (Y) and a transverse branch (5B) connecting said two branches;
- two detection coils (7), arranged one on each of the outer branches (5A) of the core (5) and intended to be connected to processing means;
- calibration means (2) positioned between the two outer branches (5A) of the magnetic core (5), a longitudinal positioning of said calibration means relative to the end of the outer branches (5A) being adjustable;
said sensor being **characterized in that** it comprises an intermediate fixing part (3) for fixing the calibration means (2) on the ferromagnetic core (5),
- said calibration means (2) comprising a threaded zone able to screw into a smooth hole formed in the intermediate fixing part so as to be displaced between the outer branches (5A);
- said intermediate fixing part (3) being placed forcibly in an opening formed in the transverse branch (5B) and comprising
- a first cylindrical zone (3A) passing through the ferromagnetic core (5) and comprising a soft end, which is deformable and truncated (3C) so as to be positioned inside the outer branches (5A) and to ensure a jamming of said part after the driving of the calibration means (2) into the smooth hole, and
- a second cylindrical zone (3B) positioned outside the core.

2. Inductive sensor according to Claim 1, **characterized in that** the first and the second cylindrical zone (3A, 3B) are connected by a shoulder zone bearing against the transverse branch (5B) of the ferromagnetic core (5).

3. Inductive sensor according to Claims 1 or 2, **characterized in that** the opening in the transverse branch (5B) of the ferromagnetic core (5) is a through-opening, and **in that** a smooth hole passes through the intermediate fixing part (3) such that a first end of the calibration means is located between the outer branches (5A) of the ferromagnetic core (5) and a second end is positioned outside said outer branches (5A).

4. Inductive sensor according to Claim 3, **characterized in that** it comprises hard resin between an inner wall of the second cylindrical zone (3B) and the outer wall of the calibration means (2).

5. Inductive sensor according to one of the preceding Claims, **characterized in that** the intermediate fixing part (3) is made of an insulating material.

6. Inductive sensor according to Claim 5, **characterized in that** the intermediate fixing part (3) comprises more than 50 % polyformaldehyde.

7. Method of mounting an inductive sensor according to the preceding claims, **characterized in that** said method consists of:
- forcibly positioning the intermediate fixing part (3) into the hole formed in the transverse branch (5B) of the ferromagnetic core (5),
- screwing, in a self-tapping manner, the calibration means (2) inside the hole formed in the intermediate fixing part (3).

8. Method of mounting an inductive sensor according to Claim 7, **characterized in that** it consists of pouring the resin into the cavity in the intermediate fixing part (3) so as to block any screwing movement of the calibration means (2) relative to the intermediate fixing part (3).
